# EUROPEAN PATENT APPLICATION

(11) **EP 3 179 727 A1**
(43) Date of publication of application: **14.06.2017**
(21) Application number: 16202375.8
(22) Date of filing: 06.12.2016
(51) Int. Cl.: H04N 21/232, H04N 21/443

(54) **VIDEO SERVER DEVICE AND WRITING/READING DATA METHOD**

(30) Priority: 09.12.2015 JP 2015240477
(71) Applicant: Kabushiki Kaisha Toshiba, Tokyo 105-8001 (JP)
(72) Inventor: Hanafusa, Yuichiro, Tokyo, 105-8001 (JP)
(74) Representative: Hoffmann Eitle

(57) **Abstract**

According to one embodiment, a video server device includes: a memory; and a memory controller. The memory controller includes: a first ECC encoding unit configured to add a first ECC code to each of first data units of the data block, each of the first data units written to memory chips in parallel; a second ECC encoding unit configured to add a second ECC code to each of second data units of the data block, each of the second data units written to the respective memory chips; a second decoding unit configured to perform, based on the second ECC code, a second error correction on each of the second data units of the data block; and a first decoding unit configured to perform, based on the first ECC code, a first error correction on each of the first data units of the data block.

## Description

This application is based upon and claims the benefit of priority from the prior Japanese Patent Application No. 2015-240477, filed December 9, 2015, the entire contents of which are incorporated herein by reference.

### FIELD

Embodiments described herein relate generally to a video server device and a writing/reading data method in which video data is written to memory chips in parallel and in which the video data written to the memory chips is read in parallel.

### BACKGROUND

A video server device includes a plurality of memory chips, and the plurality of memory chips are connected together in parallel. Actual data and ECC (Error Check and Correction) codes added thereto are written to the plurality of memory'chips in parallel. That is, ECC is performed in each of data units among the plurality of parallel memory chips. Consequently, even if any of the plurality of memory chips fails, a data error resulting from the failure can be corrected by ECC of each of the data units among the plurality of parallel memory chips.

However, a predetermined amount of data errors may occur in each of the memory chips. Conventional video server devices do not perform ECC in units of memory chips. Thus, the conventional video server devices have room for improvement in terms of the number of writes, data retention, read disturb, and the like which are provided as reliability information on the memory chips.

In the future, the memory chips may further be miniaturized and the capacity of the memory chips may further be increased based on three-dimensional structures. Furthermore, MLCs (Multi Level Cells) and thus TLCs (Triple Level Cells) may have an increased market share. This may reduce the cost of the memory chips but deteriorate the reliability of the memory chips.

As described above, the reliability of the memory chips may be deteriorated in the future, and thus, this problem is desired to be solved by ECC or the like.

### BRIEF DESCRIPTION OF THE DRAWING

FIG. 1 is a block diagram depicting a video server device according to a first embodiment;
FIG. 2 is a diagram depicting a memory controller and a memory according to the first embodiment in detail;
FIG. 3 is a block diagram depicting a configuration of an ECC circuit according to the first embodiment;
FIGS. 4, 5, 6, 7, 8, and 9 are diagrams depicting a configuration of a buffer and illustrating an ECC encoding process;
FIG. 10 is a flowchart illustrating a writing method according to the first embodiment;
FIG. 11 is a flowchart illustrating a reading method according to the first embodiment;
FIG. 12 is a block diagram depicting a configuration of an ECC circuit according to a second embodiment;
FIGS. 13, 14, 15, and 16 are diagrams depicting a configuration of a buffer according to the second embodiment and illustrating an ECC encoding process;
FIG. 17 is a flowchart illustrating a writing method according to the second embodiment;
FIG. 18 is a flowchart illustrating a reading method according to the second embodiment;
FIG. 19 is a diagram depicting a configuration of a buffer according to a third embodiment and illustrating an ECC encoding process;
FIG. 20 is a flowchart illustrating a writing method according to the third embodiment; and
FIG. 21 is a flowchart illustrating a reading method according to the third embodiment.

### DETAILED DESCRIPTION

In general, according to one embodiment, a video server device includes: a memory including memory chips; and a memory controller configured to write a data block to the memory chips in parallel and to read the data block written to the memory chips in parallel. The memory controller includes: a first ECC encoding unit configured to add a first ECC code to each of first data units of the data block, each of the first data units written to the memory chips in parallel; a second ECC encoding unit configured to add a second ECC code to each of second data units of the data block with the first ECC code added thereto, each of the second data units written to the respective memory chips; a second decoding unit configured to perform, based on the second ECC code, a second error correction on each of the second data units of the data block with the second ECC code added thereto; and a first decoding unit configured to perform, based on the first ECC code, a first error correction on each of the first data units of the data block subjected to the second error correction.

The present embodiments will be described below with reference to the drawings. In the drawings, the same components are denoted by the same reference numerals.

### <First Embodiment>

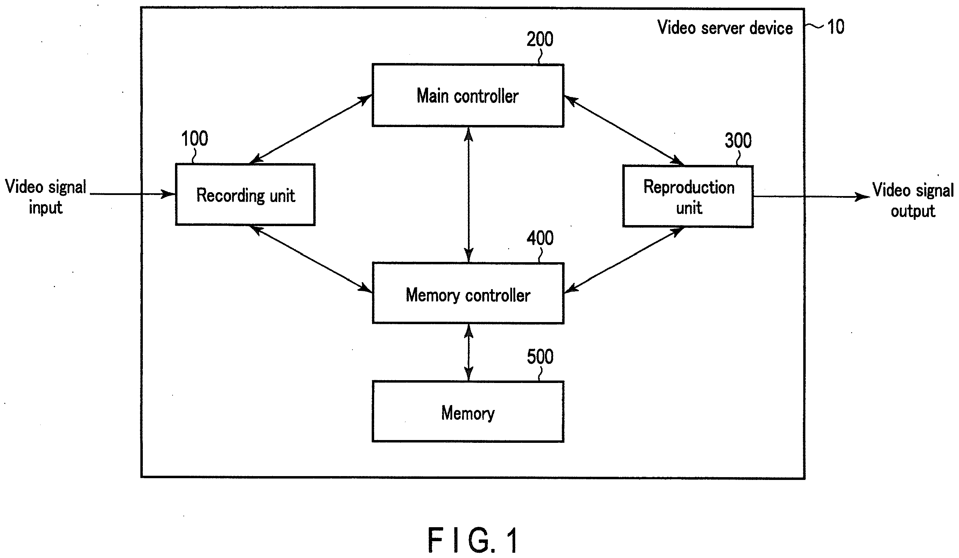

Using FIGS. 1, 2, 3, 4, 5, 6, 7, 8, 9, 10, and 11, a video server device according to a first embodiment will be described.

### (Configuration in the First Embodiment)

FIG. 1 is a block diagram depicting a video server device 10 according to the first embodiment.

As depicted in FIG. 1, the video server device 10 comprises a recording unit 100, a main controller 200, a reproduction unit 300, a memory controller 400, and a memory 500.

The main controller 200 controls the device as a whole. The recording unit 100 encodes a video signal received from a camera, a video cassette recorder, or the like into video data and performs recording processing on the video data. The memory controller 400 writes the video data from the recording unit 100 to the memory 500. The memory controller 400 also reads the video data stored in the memory 500. The memory 500 is a nonvolatile memory, for example, a NAND flash memory. The reproduction unit 300 decodes the video data read from the memory 500 into the video signal and outputs the video signal.

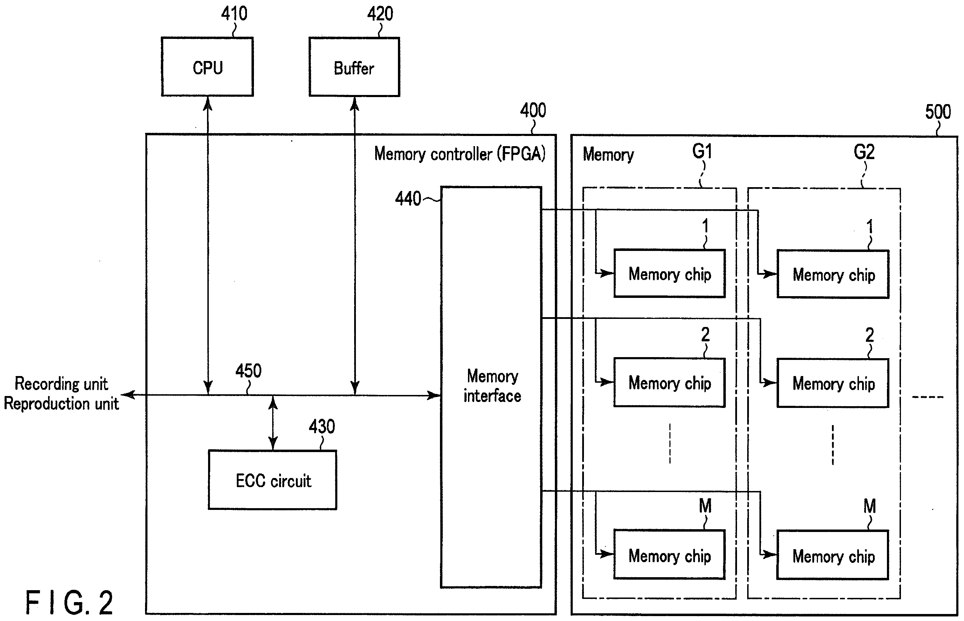

FIG. 2 is a diagram depicting the memory controller 400 and the memory 500 according to the first embodiment in detail.

As depicted in FIG. 2, the memory 500 includes a plurality of memory chip groups G1, G2, ... Each of the memory chip groups G comprises a plurality of memory chips 1 to M. The memory chips 1 to M are connected to a memory interface 440 in parallel. Thus, in write and read operations, the memory chips 1 to M in each memory chip group G are accessed in parallel.

The memory controller 400 controls write to the memory 500 in accordance with an external write command. The memory controller 400 also controls read from the memory 500 in accordance with an external read command. The memory controller 400 is, for example, an FPGA (Field Programmable Gate Array), and comprises an ECC circuit 430 and the memory interface 440. The ECC circuit 430 and the memory interface 440 are connected together via an internal bus 450. The ECC circuit 430 and the memory interface 440 are also connected via the internal bus 450 to a CPU 410 and a buffer 420 located outside the memory controller 400. The CPU 410 may be provided in the memory controller 400.

The buffer 420 temporarily stores externally received video data until the video data is written to the memory 500 or until video data read from the memory 500 is transmitted to the outside. The buffer 420 is a RAM (Random Access Memory), for example, a general-purpose memory such as an SRAM (Static Random Access Memory), a DRAM (Dynamic Random Access Memory), or an MRAM (Magnetic Random Access Memory).

A predetermined capacity of external video data is accumulated in the buffer 420 as a data block. The predetermined capacity is set according to the number of memory chips 1 to M arranged in parallel in one memory chip group G. For example, the predetermined capacity is determined by subtracting the capacity of added ECC codes from the total capacity of the memory chips 1 to M in one memory chip group G. That is, addition of ECC codes to the predetermined capacity of data block results in the total capacity of memory chips 1 to M.

The ECC circuit 430 adds ECC codes to a data block (video data) stored in the buffer 420 (ECC encoding). A scheme for ECC encoding is optional, and examples of the scheme include BCH (Bose Chaudhuri Hocquenghem), RS (Reed Solomon), and LDPC (Low Density Parity Check). The ECC circuit 430 performs error correction on the data block with the ECC code added thereto, based on the ECC code. The ECC circuit 430 will be described below in detail.

The CPU 410 integrally controls the memory controller 400. Upon receiving an external command, the CPU 410 performs control in accordance with the command. For example, the CPU 410 instructs the memory interface 440 to write video data to the memory 500, in accordance with an external write command. The CPU 410 also instructs the memory interface 440 to read video data from the memory 500, in accordance with an external read command.

The memory interface 440 writes or reads video data or the like to or from the memory 500 based on the instruction from the CPU 410. In this case, the memory interface 440 writes video data to the plurality of memory chips 1 to M in each memory chip group G in parallel. The memory interface 440 also reads the video data from the plurality of memory chips 1 to M in each memory chip group G in parallel.

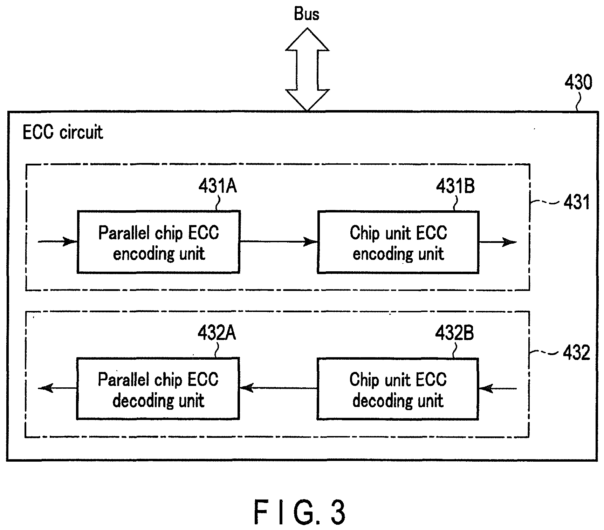

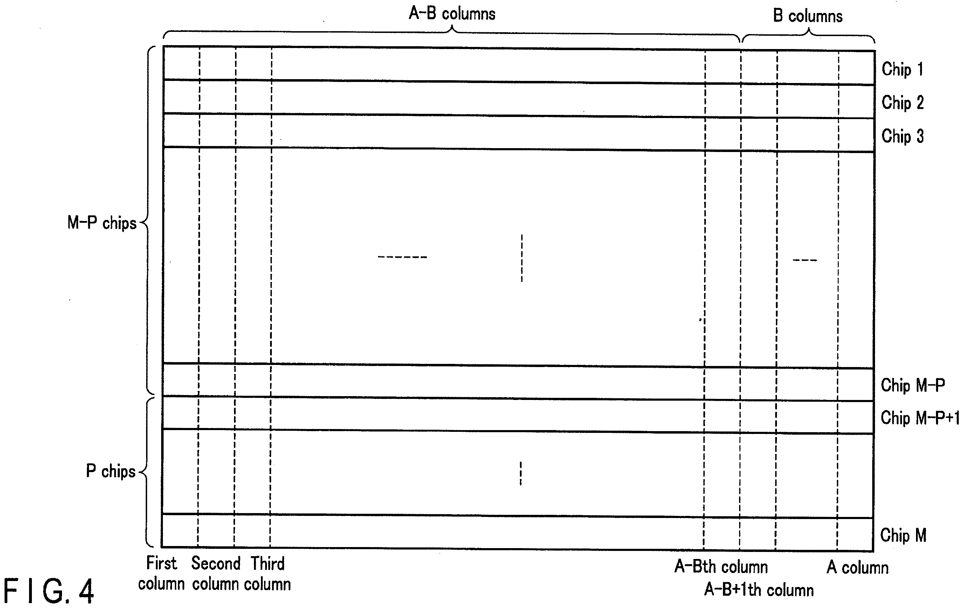

FIG. 3 is a block diagram depicting a configuration of the ECC circuit 430 according to the first embodiment. FIGS. 4, 5, 6, 7, 8, and 9 are diagrams depicting a configuration of the buffer 420 according to the first embodiment and illustrating an ECC encoding process.

As depicted in FIG. 3, the ECC circuit 430 comprises a write circuit 431 and a read circuit 432.

The write circuit 431 comprises a parallel chip ECC encoding unit 431A and a chip unit ECC encoding unit 431B.

The parallel chip ECC encoding unit 431A adds a first ECC code to a data block received by the buffer 420. The first ECC code is added to each first data unit in the data block in the buffer 420. The first data unit corresponds to one column of data unit written to the plurality of memory chips in parallel. The chip unit ECC encoding unit 431B adds a second ECC code to the data block with the first ECC code added thereto. The second ECC code is added to a second data unit of each data block of the buffer 420. The second data unit corresponds to a data unit written to each memory chip. The first ECC code and the second ECC code will be described below in detail.

As depicted in FIG. 4, the buffer 420 has a memory capacity comparable to the memory capacity of the plurality of memory chips 1 to M in one memory chip group G. In this case, each of the memory chips includes a storage area of a first to an Ath columns (for example, one column includes 1 byte (8 bits)).

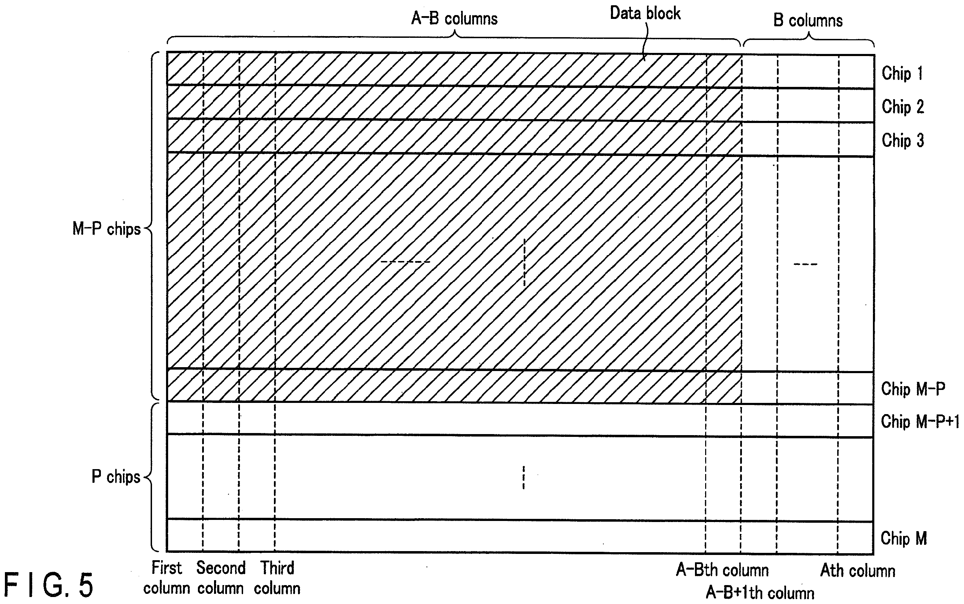

First, as depicted in FIG. 5, a predetermined capacity of external video data is accumulated in the buffer 420 as a data block. The predetermined capacity corresponds to a first to an A - Bth columns of each of memory chips 1 to M - P.

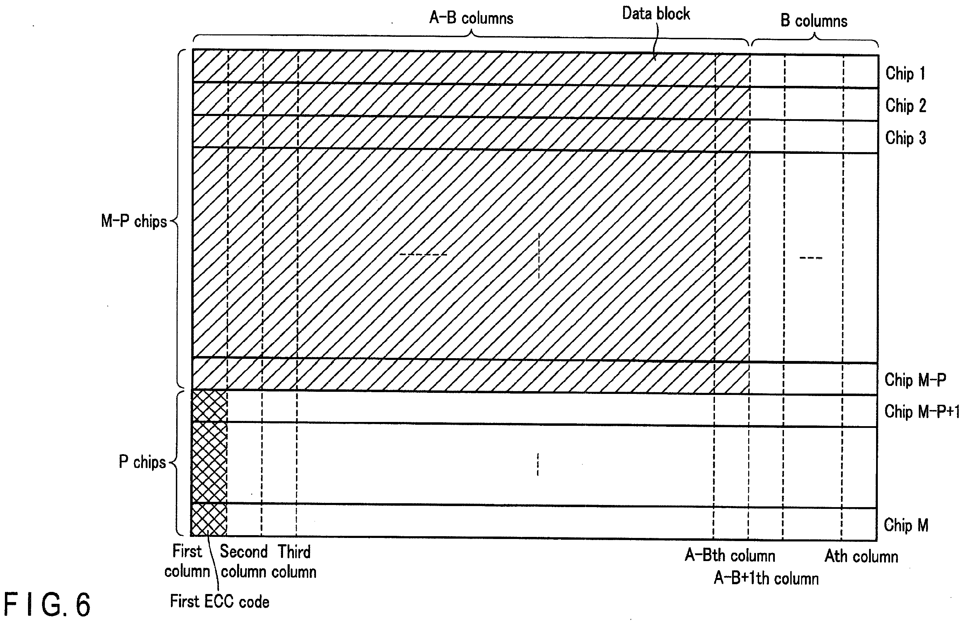

As depicted in FIG. 6, the parallel chip ECC encoding unit 431A adds a first ECC code to each first data unit in the data block. The first data unit corresponds to one column of M - P memory chips (M - P bytes). The first ECC code corresponds to the data in one column of P memory chips (P bytes). That is, a combination of the first data unit and the first ECC code correspond to the data in one column of M memory chips (M bytes). Therefore, first, the parallel chip ECC encoding unit 431A adds the first ECC code to one column of memory chips M - P + 1 to M for the data in one column of memory chips 1 to M - P, as depicted in FIG. 6.

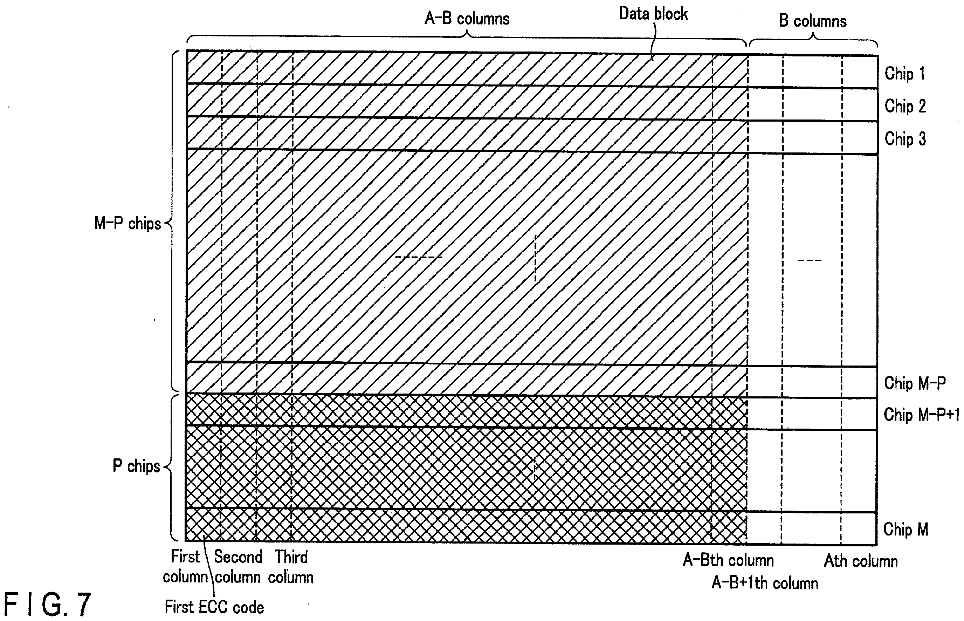

Subsequently, the parallel chip ECC encoding unit 431A similarly sequentially adds the first ECC code to each of the first data units in the data block as depicted in FIG. 7. Eventually, the parallel chip ECC encoding unit 431A adds the first ECC code to the A - B columns of each of the memory chips M - P + 1 to M for the data in the A - B columns of each of the memory chips 1 to M - P.

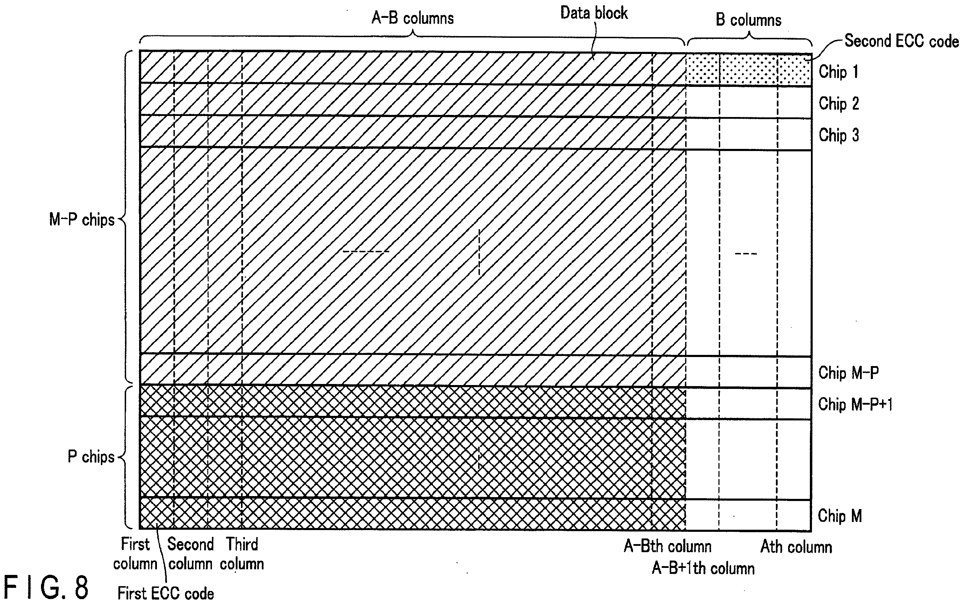

Then, as depicted in FIG. 8, the chip unit ECC encoding unit 431B adds a second ECC code to each second data unit in the data block. The second data unit corresponds to the data in A - B columns of one memory chip (A - B bytes). The second ECC code corresponds to the data in B columns of one memory chip (B bytes). That is, a combination of the second data unit and the second ECC code corresponds to the data in A columns of one memory chip (A bytes). Therefore, first, the chip unit ECC encoding unit 431B adds the second ECC code to the A - B + 1th to the Ath columns of the memory chip 1 for the data in the first to the A - Bth columns of the memory chip 1, as depicted in FIG. 8.

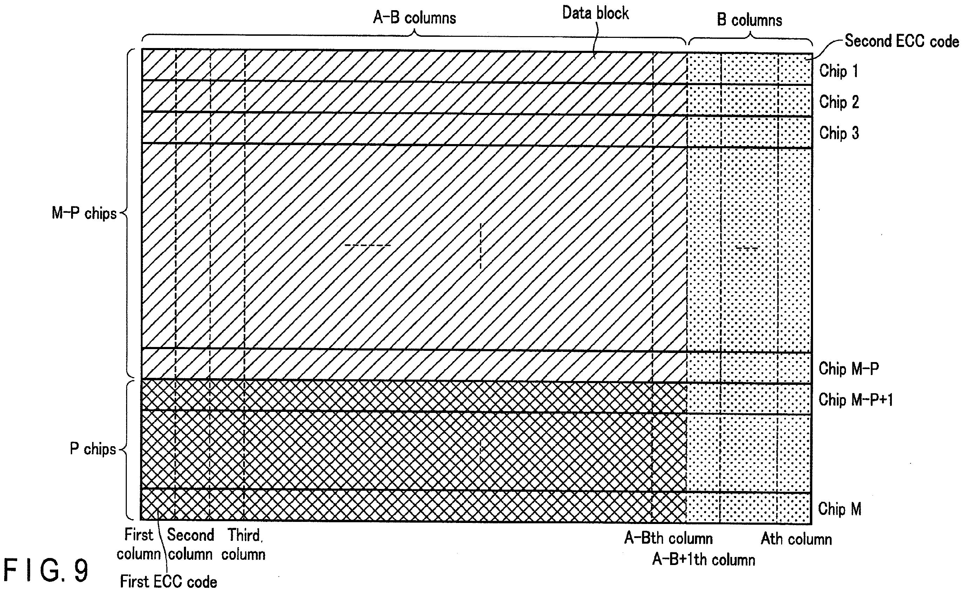

Subsequently, the chip unit ECC encoding unit 431B similarly sequentially adds the second ECC code to each of the second data units in the data block as depicted in FIG. 9. Finally, the chip unit ECC encoding unit 431B adds the second ECC code to the A - B + 1th to the Ath columns of the memory chip M for the data in the first to the A - Bth columns of the memory chip M.

As described above, in the buffer 420, the first to the A - Bth columns of each of the memory chips 1 to M - P correspond to a data area, the first to the A - Bth columns of each of the memory chips M - P + 1 to M correspond to a first ECC area, and the A - B + 1th to the Ath columns of each of the memory chips 1 to M correspond to a second ECC area.

The memory interface 440 sequentially writes the data block with the first ECC code and the second ECC code added thereto in parallel starting with data corresponding to one column of the memory chips 1 to M, based on the instruction from the CPU 410.

As depicted in FIG. 3, the read circuit 432 has a chip unit ECC decoding unit 432B and a parallel chip ECC decoding unit 432A.

The chip unit ECC decoding unit 432B performs a second error correction on a data block read in the buffer 420 based on the second ECC code. The second error correction is performed on each of the second data units in the data block in the buffer 420. The parallel chip ECC decoding unit 432A performs a first error correction on the data block in the buffer 420 subjected to the second error correction, based on the first ECC code. The first error correction is performed on each of the first data units in the data block in the buffer 420. The CPU 410 transmits the data block subjected to the first error correction and the second error correction to the outside.

### (Writing Data Method in the First Embodiment)

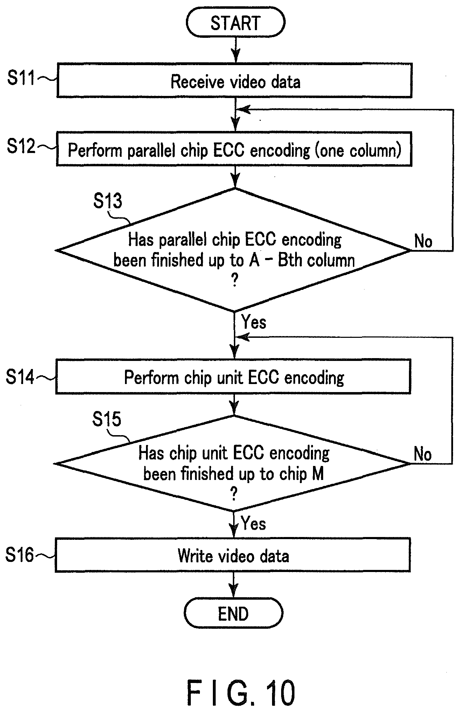

FIG. 10 is a flowchart illustrating a writing method according to the first embodiment.

As illustrated in FIG. 10, first, in step S11, the buffer 420 receives external video data and a predetermined capacity of video data is accumulated in the buffer 420 as a data block. At this time, the data block is accumulated in the buffer 420 to a capacity corresponding to the first to the A - Bth columns of each of the memory chips 1 to M - P.

Then, in step S12, the parallel chip ECC encoding unit 431A performs parallel chip ECC encoding. That is, the first ECC code is added to each first data unit in the data block. At this time, the first data unit corresponds to one column of M - P memory chips (M - P bytes). The first ECC code corresponds to the data in one column of P memory chips (P bytes).

Subsequently, in step S13, the process determines whether or not the parallel chip ECC encoding has been finished up to the A - Bth column.

In step S13, if the parallel chip ECC encoding has not been finished up to the A - Bth column, the process returns to step S12, where the parallel chip ECC encoding unit 431A performs the parallel chip ECC encoding.

In step S13, if the parallel chip ECC encoding has been finished up to the A - Bth column, then in step S14, the chip unit ECC encoding unit 431B performs chip unit ECC encoding. That is, the second ECC code is added to each second data unit in the data block. At this time, the second data unit corresponds to the data in A - B columns of one memory chip (A - B bytes). The second ECC code corresponds to the data in B columns of one memory chip (B bytes).

Subsequently, in step S15, the process determines whether or not chip unit ECC encoding has been finished up to the memory chip M.

In step S15, if the chip unit ECC encoding has not been finished up to the memory chip M, the process returns to step S14, where the chip unit ECC encoding unit 431B performs the chip unit ECC encoding.

In step S15, if the chip unit ECC encoding has been finished up to the memory chip M, then in step S16, the memory interface 440 writes video data to the memory chips 1 to M. That is, the data block with the first ECC code and the second ECC code added thereto is sequentially written in parallel starting with data corresponding to one column of the memory chips 1 to M.

### (Reading Data Method in the First Embodiment)

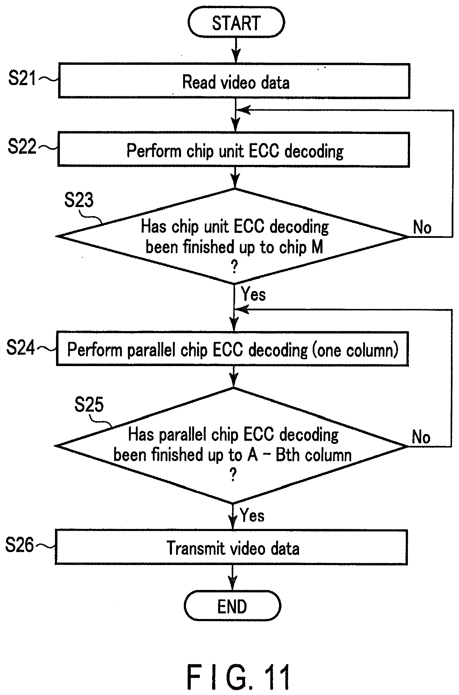

FIG. 11 is a flowchart illustrating a reading method according to the first embodiment.

As illustrated in FIG. 11, first, in step S21, the memory interface 440 reads the video data from the memory chips 1 to M. That is, a data block with the first ECC code and the second ECC code added thereto is sequentially read in parallel starting with one row of the memory chips 1 to M.

Then, in step S22, the chip unit ECC decoding unit 432B performs chip unit ECC decoding. That is, the second error correction is performed on the data block based on the second ECC code. The second error correction is performed on each of the second data units in the data block in the buffer 420.

Subsequently, in step S23, the process determines whether or not the chip unit ECC decoding has been finished up to the memory chip M.

In step S23, if the chip unit ECC decoding has not been finished up to the memory chip M, the process returns to step S22, where the chip unit ECC decoding unit 432B performs the chip unit ECC decoding.

In step S23, if the chip unit ECC decoding has been finished up to the memory chip M, then in step S24, the parallel chip ECC decoding unit 432A performs parallel chip ECC decoding. That is, the first error correction is performed on the data block based on the first ECC code. The first error correction is performed on each of the first data units in the data block in the buffer 420.

Subsequently, in step S25, the process determines whether or not the parallel chip ECC decoding has been finished up to the A - Bth column.

In step S25, if the parallel chip ECC decoding has not been finished up to the A - Bth column, the process returns to step S24, where the parallel chip ECC encoding unit 431A performs the parallel chip ECC decoding.

In step S25, if the parallel chip ECC decoding has been finished up to the A - Bth column, then in step S26, the CPU 410 transmits the video data (data block) subjected to the first error correction and the second error correction to the outside.

### (Effects of the First Embodiment)

In the above-described first embodiment, the ECC circuit 430 comprises the parallel chip ECC encoding unit 431A and the chip unit ECC encoding unit 431B. The parallel chip ECC encoding unit 431A adds the first ECC code to the received data block. The first ECC code is added to each of the data units written to the plurality of memory chips in parallel. That is, the addition of the first ECC code is performed among the plurality of parallel memory chips. Consequently, even if any of the plurality of memory chips fails, other memory chips can compensate for the failure, allowing correction of a data error resulting from the failure.

On the other hand, the chip unit ECC encoding unit 431B adds the second ECC code to the data block. The second ECC code is added to each of the data units written to the respective memory chips. Thus, ECC specifications in units of memory chips can be sufficiently satisfied.

### <Second Embodiment>

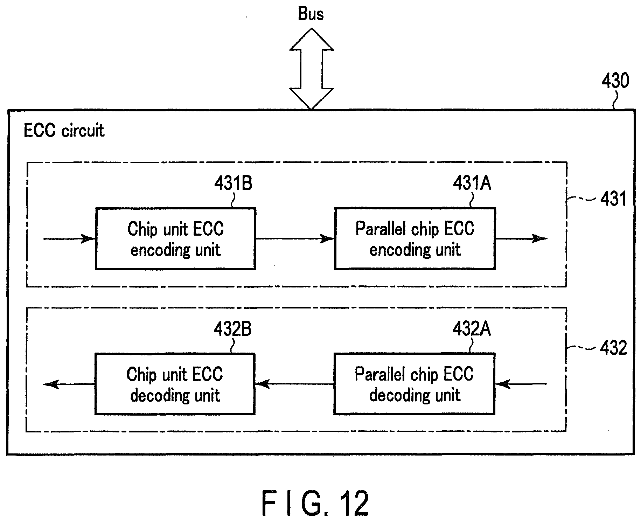

Using FIGS. 12, 13, 14, 15, 16, 17, and 18, a semiconductor storage device according to a second embodiment will be described. In the second embodiment, the addition of the first ECC code and the second ECC code is executed in an order different from the order in the first embodiment. The second embodiment will be described below in detail.

Aspects of the second embodiment which are similar to the corresponding aspects of the first embodiment will not be described, and the following description focuses on differences from the first embodiment.

### (Configuration in the Second Embodiment)

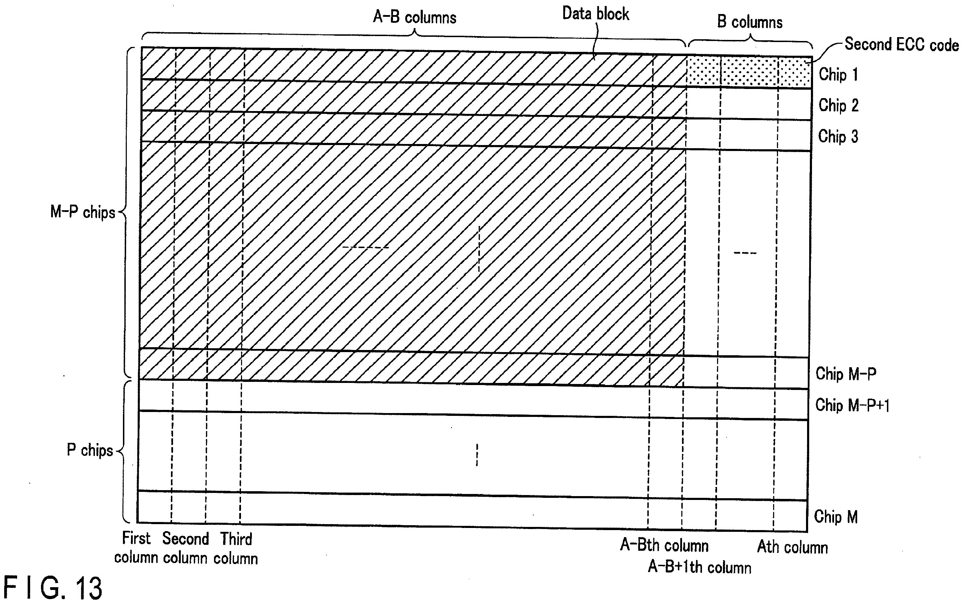

FIG. 12 is a block diagram of a configuration of the ECC circuit 430 according to the second embodiment. FIGS. 13, 14, 15, and 16 depict a configuration of the buffer 420 according to the second embodiment and illustrate an ECC encoding process.

As illustrated in FIG. 12, in the second embodiment, the chip unit ECC encoding unit 431B adds the second ECC code to the data block received by the buffer 420. The parallel chip ECC encoding unit 431A adds the first ECC code to the data block with the second ECC code added thereto. The first ECC code and the second ECC code will be described below in detail.

First, as is the case with the first embodiment, a predetermined capacity of external video data is accumulated in the buffer 420 as a data block as depicted in FIG. 5.

Then, as depicted in FIG. 13, the chip unit ECC encoding unit 431B adds the second ECC code to each second data unit in the data block. More specifically, first, the chip unit ECC encoding unit 431B adds the second ECC code to the A - B + 1th to the Ath columns of the memory chip 1 for the data in the first to the A - Bth columns of the memory chip 1.

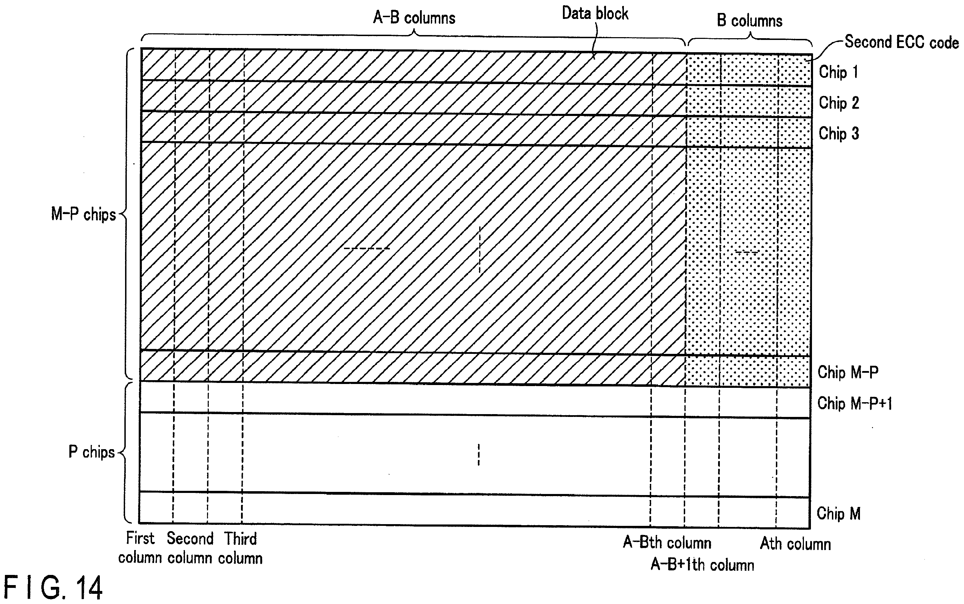

Subsequently, similarly, the chip unit ECC encoding unit 431B sequentially adds the second ECC code to each second data unit in the data block as illustrated in FIG. 14. Eventually, the chip unit ECC encoding unit 431B adds the second ECC code to the A - B + 1th to the Ath columns of the memory chip M - P for the data for the first to the A - Bth columns of the memory chip M - P.

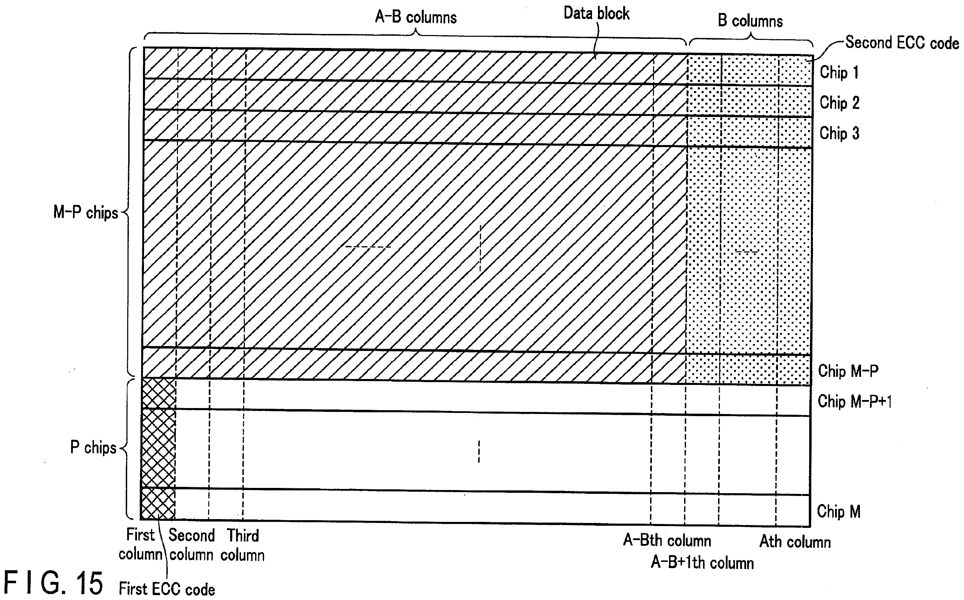

Then, as depicted in FIG. 15, the parallel chip ECC encoding unit 431A adds the first ECC code to each first data unit in the data block. More specifically, first, the parallel chip ECC encoding unit 431A adds the first ECC code to one column of the memory chips M - P + 1 to M for the data in one row of the memory chips 1 to M - P.

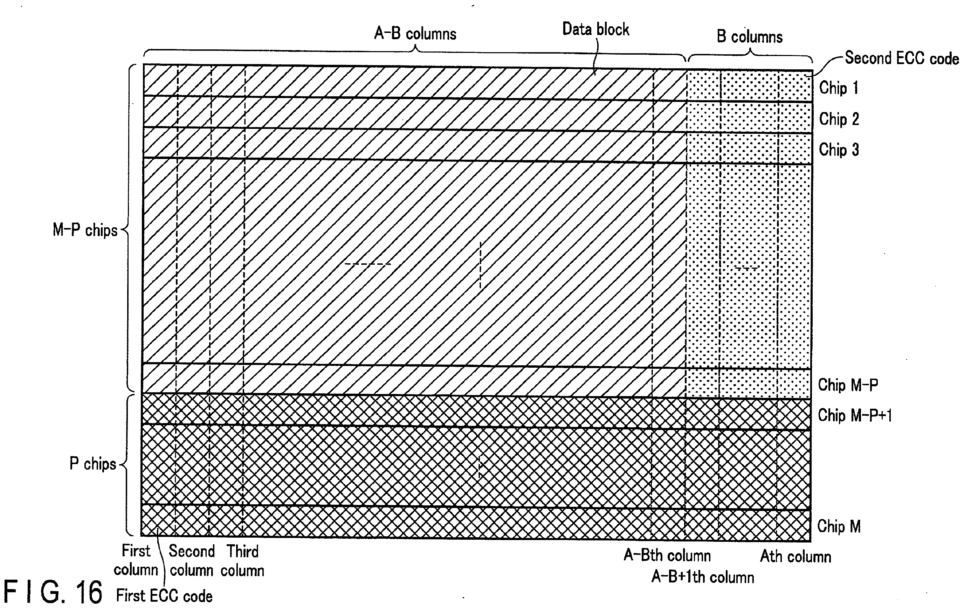

Subsequently, the parallel chip ECC encoding unit 431A similarly sequentially adds the first ECC code to each of the first data units in the data block as depicted in FIG. 16. Eventually, the parallel chip ECC encoding unit 431A adds the first ECC code to the A columns of each of the memory chips M - P + 1 to M for the data in the A columns of each of the memory chips 1 to M - P.

As described above, in the buffer 420, the first to the A - Bth columns of each of the memory chips 1 to M - P correspond to a data area, the first to the Ath columns of each of the memory chips M - P + 1 to M correspond to the first ECC area, and the A - B + 1th to the Ath columns of each of the memory chips 1 to M - P correspond to the second ECC area.

Then, as illustrated in FIG. 12, the parallel chip ECC decoding unit 432A performs the first error correction on the data block read in the buffer 420 based on the first ECC code. The chip unit ECC decoding unit 432B performs, based on the second ECC code, the second error correction on the data block in the buffer 420 subjected to the first error correction. The CPU 410 transmits the data block subjected to the first error correction and the second error correction to the outside.

### (Writing Data Method in the Second Embodiment)

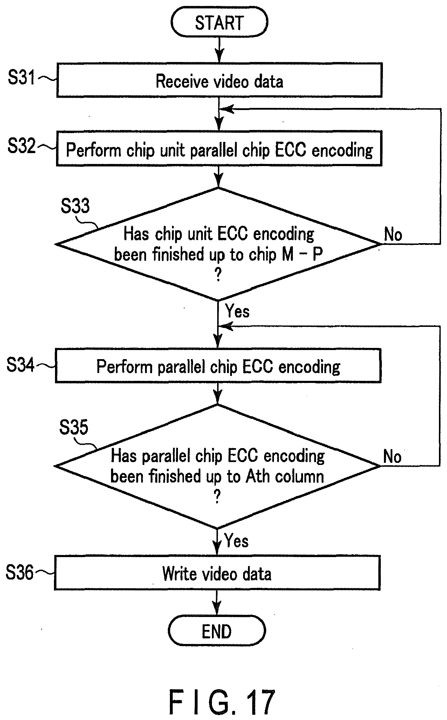

FIG. 17 is a flowchart illustrating a writing method according to the second embodiment.

As illustrated in FIG. 17, first, in step S31, the buffer 420 receives external video data and a predetermined capacity of video data is accumulated in the buffer 420 as a data block.

Then, in step S32, the chip unit ECC encoding unit 431B performs the chip unit ECC encoding. That is, the second ECC code is added to each second data unit in the data block.

Subsequently, in step S33, the process determines whether or not the chip unit ECC encoding has been finished up to the memory chip M - P.

In step S33, if the chip unit ECC encoding has not been finished up to the memory chip M - P, the process returns to step S32, where the chip unit ECC encoding unit 431B performs the chip unit ECC encoding.

In step S33, if the chip unit ECC encoding has been finished up to the memory chip M - P, then in step S34, the parallel chip ECC encoding unit 431A performs the parallel chip ECC encoding. That is, the first ECC code is added to each first data unit in the data block. At this time, the first data unit corresponds to one column of M - P memory chips (M - P bytes). The first ECC code corresponds to the data in one column of P memory chips (P bytes).

Subsequently, in step S35, the process determines whether or not the parallel chip ECC encoding has been finished up to the Ath column.

In step S35, if the parallel chip ECC encoding has not been finished up to the Ath column, the process returns to step S34, where the parallel chip ECC encoding unit 431A performs the parallel chip ECC encoding.

In step S35, if the parallel chip ECC encoding has been finished up to the Ath column, then in step S36, the memory interface 440 writes the video data to the memory chips 1 to M. That is, the data block with the first ECC code and the second ECC code added thereto is sequentially written in parallel starting with data corresponding to one column of the memory chips 1 to M.

### (Reading Data Method in the Second Embodiment)

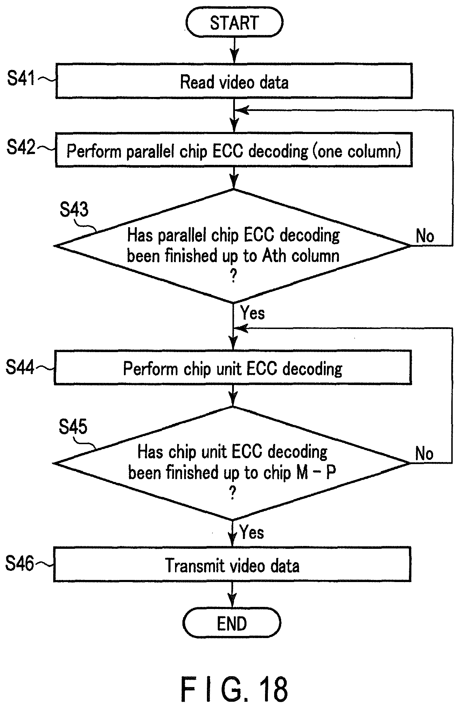

FIG. 18 is a flowchart illustrating a reading method according to the second embodiment.

As illustrated in FIG. 18, first, in step S41, the memory interface 440 reads the video data from the memory chips 1 to M. That is, a data block with the first ECC code and the second ECC code added thereto is sequentially read in parallel starting with one column of the memory chips 1 to M.

Then, in step S42, the parallel chip ECC decoding unit 432A performs the parallel chip ECC decoding. That is, the first error correction is performed on the data block based on the first ECC code. The first error correction is performed on each of the first data units in the data block in the buffer 420.

Subsequently, in step S43, the process determines whether or not the parallel chip ECC decoding has been finished up to the Ath column.

In step S43, if the parallel chip ECC decoding has not been finished up to the Ath column, the process returns to step S42, where the parallel chip ECC decoding unit 432A performs the parallel chip ECC encoding.

In step S43, if the parallel chip ECC decoding has been finished up to the Ath column, then in step S44, the chip unit ECC decoding unit 432B performs the chip unit ECC decoding. That is, the second error correction is performed on the data block based on the second ECC code. The second error correction is performed on each of the second data unit in the data block in the buffer 420.

Subsequently, in step S45, the process determines whether or not the chip unit ECC decoding has been finished up to the memory chip M - P.

In step S45, if the chip unit ECC decoding has not been finished up to the memory chip M - P, the process returns to step S44, where the chip unit ECC decoding unit 432B performs the chip unit ECC decoding.

In step S45, if the chip unit ECC decoding has been finished up to the memory chip M - P, then in step S46, the CPU 410 transmits the video data (data block) subjected to the first error correction and the second error correction to the outside.

### (Effects of the Second Embodiment)

In the second embodiment, after the chip unit ECC encoding unit 431B adds the second ECC code to the data block, the parallel chip ECC encoding unit 431A adds the first ECC code to the received data block. That is, in the second embodiment, the addition of the first ECC code and the second ECC code is executed in the order reverse to the order in the first embodiment. This allows realization of effects similar to the effects of the first embodiment.

### <Third Embodiment>

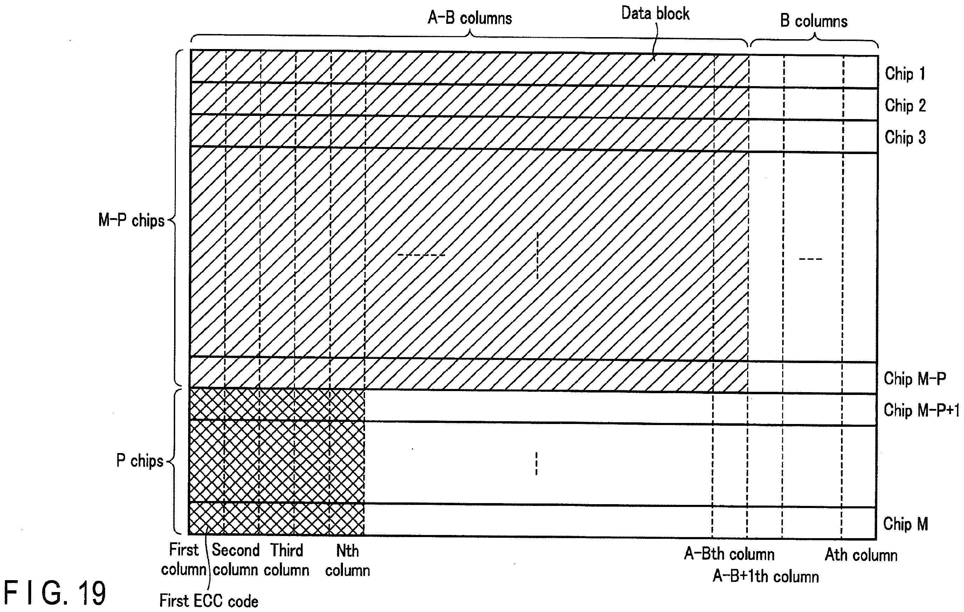

Using FIGS. 19, 20, and 21, a semiconductor storage device according to a third embodiment will be described. The third embodiment involves a larger first data unit than the first embodiment. This enables a reduction in the probability that data errors during read and write are uncorrectable, allowing the reliability to be further enhanced. The third embodiment will be described in detail.

Aspects of the third embodiment which are similar to the corresponding aspects of the first embodiment will not be described, and the following description focuses on differences from the first embodiment.

### (Configuration of the Third Embodiment)

FIG. 19 is a diagram depicting a configuration of the buffer 420 according to the third embodiment and illustrating an ECC encoding process.

In the third embodiment, the first data unit corresponds to N columns of data units written to the plurality of memory chips in parallel.

The first ECC code and the second ECC code will be described below in detail.

First, as is the case with the first embodiment, a predetermined capacity of external video data is accumulated in the buffer 420 as a data block as depicted in FIG. 5.

As depicted in FIG. 19, the parallel chip ECC encoding unit 431A adds a first ECC code to each first data unit in the data block. The first data unit corresponds to the data in N columns of each of M - P memory chips ((M - P) × N bytes). The first ECC code corresponds to the data in N columns of each of P memory chips (P × N bytes). That is, a combination of the first data unit and the first ECC code corresponds to the data in N columns of each of M chips written in parallel (M × N bytes). Therefore, first, the parallel chip ECC encoding unit 431A adds the first ECC code to the first to the Nth columns of each of the memory chips M - P + 1 to M for the data in the first to the Nth columns of each of the memory chips 1 to M - P as depicted in FIG. 19.

Subsequently, the parallel chip ECC encoding unit 431A similarly sequentially adds the first ECC code to each first data unit in the data block. Eventually, the parallel chip ECC encoding unit 431A adds the first ECC code to the A - B columns of each of the memory chips M - P + 1 to M for the data in the A - B columns of each of the memory chips 1 to M - P.

Subsequently, operations similar to the corresponding operations in the first embodiment are performed. That is, the chip unit ECC encoding unit 431B adds the second ECC code to each second data unit in the data block. The memory interface 440 sequentially writes the data block with the first ECC code and the second ECC code added thereto in parallel, based on the instruction from the CPU 410, starting with the data corresponding to the first to the Nth columns of each of the memory chips 1 to M.

### (Writing Data Method in the Third Embodiment)

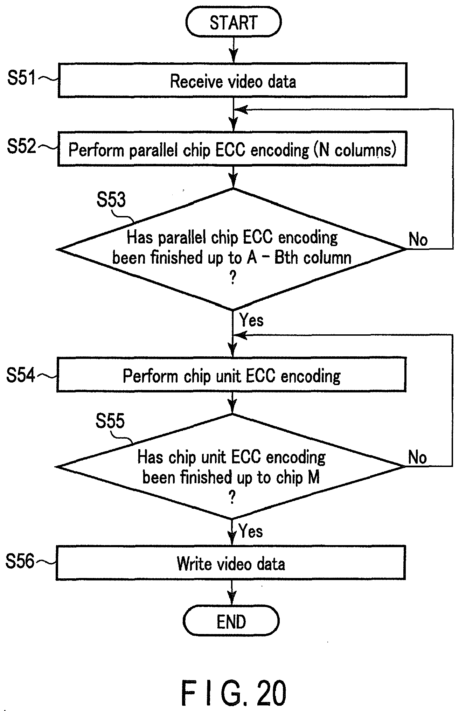

FIG. 20 is a flowchart illustrating a writing method according to the third embodiment.

As illustrated in FIG. 20, first, in step S51, the buffer 420 receives external video data, and a predetermined capacity of video data is accumulated in the buffer 420 as a data block as is the case with the first embodiment.

Then, in step S52, the parallel chip ECC encoding unit 431A performs the parallel chip ECC encoding. That is, the first ECC code is added to each first data unit in the data block. At this time, the first data unit corresponds to the data in N columns of each of M - P memory chips ((M - P) × bytes). The first ECC code corresponds to the data in N columns of each of P memory chips (P × N bytes).

Subsequently, in step S53, the process determines whether or not the parallel chip ECC encoding has been finished up to the A - Bth column.

In step S53, if the parallel chip ECC encoding has not been finished up to the A - Bth column, the process returns to step S52, where the parallel chip ECC encoding unit 431A performs the parallel chip ECC encoding on each of the first data units (every (M - P) × N bytes).

In step S53, if the parallel chip ECC encoding has been finished up to the A - Bth column, then in steps S54 to S56, operations similar to the corresponding operations in the first embodiment are performed. That is, the chip unit ECC encoding unit 431B performs the chip unit ECC encoding, and the memory interface 440 writes the video data to the memory chips 1 to M.

### (Reading Data Method in the Third Embodiment)

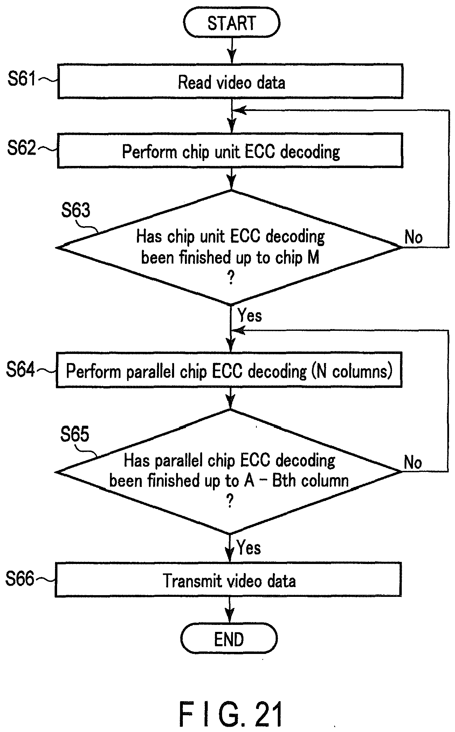

FIG. 21 is a flowchart illustrating a reading method according to the third embodiment.

As illustrated in FIG. 21, first, operations similar to the corresponding operations in the first embodiment are performed in steps S61 to S63. That is, the buffer 420 receives external video data, and the chip unit ECC encoding unit 431B performs the chip unit ECC encoding.

Then, in step S64, the parallel chip ECC decoding unit 432A performs the parallel chip ECC decoding. That is, the first error correction is performed on the data block based on the first ECC code. The first error correction is performed on each of the first data units (every (M - P) × N bytes))

Subsequently, in step S65, the process determines whether or not the parallel chip ECC decoding has been finished up to the A - Bth column.

In step S65, if the parallel chip ECC decoding has not been finished up to the A - Bth column, the process returns to step S24, where the parallel chip ECC encoding unit 431A performs the parallel chip ECC encoding on each of the first data units (every (M - P) × N bytes).

In step S65, if the parallel chip ECC decoding has been finished up to the A - Bth column, then in step S66, the CPU 410 transmits the video data (data block) subjected to the first error correction and the second error correction to the outside as is the case with the first embodiment.

### (Effects of the Third Embodiment)

The third embodiment involves a larger first data unit than the first embodiment. More specifically, the first data unit corresponds to N (2 ≤ N ≤ A - B) columns of each of M - P memory chips. The first ECC code corresponds to N columns of each of P memory chips. As described above, since the first data unit to which the first ECC code is added is increased, the third embodiment can reduce the probability that data errors during read and write are uncorrectable, allowing the reliability to be further enhanced, compared to the first embodiment.

The third embodiment and the second embodiment may be combined together.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A video server device comprising:
a memory including memory chips; and
a memory controller configured to write a data block to the memory chips in parallel and to read the data block written to the memory chips in parallel,
wherein the memory controller comprises:
a first ECC encoding unit configured to add a first ECC code to each of first data units of the data block, each of the first data units written to the memory chips in parallel;
a second ECC encoding unit configured to add a second ECC code to each of second data units of the data block with the first ECC code added thereto, each of the second data units written to the respective memory chips;
a second decoding unit configured to perform, based on the second ECC code, a second error correction on each of the second data units of the data block with the second ECC code added thereto; and
a first decoding unit configured to perform, based on the first ECC code, a first error correction on each of the first data units of the data block subjected to the second error correction.

2. The device of claim 1, wherein each of the first data units corresponds to one column of data written to the memory chips in parallel.

3. The device of claim 1, wherein each of the first data units corresponds to columns of data written to the memory chips in parallel.

4. The device of claim 1, wherein the data block and the second ECC code are written to first memory chips of the memory chips, and the first ECC code and the second ECC code are written to second memory chips of the memory chips.

5. A writing/reading data method of writing a data block to memory chips in parallel and reading the data block written to the memory chips in parallel, the method comprising:
adding a first ECC code to each of first data units of the data block, each of the first data units written to the memory chips in parallel;
adding a second ECC code to each of second data units of the data block with the first ECC code added thereto, each of the second data units written to the respective memory chips;
performing, based on the second ECC code, a second error correction on each of the second data units of the data block with the second ECC code added thereto; and
performing, based on the first ECC code, a first error correction on each of the first data units of the data block subjected to the second error correction.

6. The method of claim 5, wherein each of the first data units corresponds to one column of data written to the memory chips in parallel.

7. The method of claim 5, wherein each of the first data units corresponds to columns of data written to the memory chips in parallel.

8. The device of claim 5, wherein the data block and the second ECC code are written to first memory chips of the memory chips, and the first ECC code and the second ECC code are written to second memory chips of the memory chips.

9. A video server device comprising:
a memory including memory chips; and
a memory controller configured to write a data block to the memory chips in parallel and to read the data block written to the memory chips in parallel,
wherein the memory controller comprises:
a second ECC encoding unit configured to add a second ECC code to each of second data units of the data block, each of the second data units written to the respective memory chips;
a first ECC encoding unit configured to add a first ECC code to each of first data units of the data block with the second ECC code added thereto, each of the first data units written to the memory chips in parallel;
a first decoding unit configured to perform, based on the first ECC code, a first error correction on each of the first data units of the data block with the first ECC code added thereto; and
a second decoding unit configured to perform, based on the second ECC code, a second error correction on each of the second data units of the data block subjected to the first error correction.

10. The device of claim 9, wherein each of the first data units corresponds to one column of data written to the memory chips in parallel.

11. The device of claim 9, wherein each of the first data units corresponds to columns of data units written to the memory chips in parallel.

12. The device of claim 9, wherein the data block and the second ECC code are written to first memory chips of the memory chips, and the first ECC code is written to second memory chips of the memory chips.

13. A writing/reading data method of writing a data block to memory chips in parallel and reading the data block written to the memory chips in parallel, the method comprising:
adding a second ECC code to each of second data units of the data block, each of the second data units written to the respective memory chips;
adding a first ECC code to each of first data units of the data block with the second ECC code added thereto, each of the first data units written to the memory chips in parallel;
performing, based on the first ECC code, a first error correction on each of the first data units of the data block with the first ECC code added thereto; and
performing, based on the second ECC code, a second error correction on each of the second data units of the data block subjected to the first error correction.

14. The method of claim 13, wherein each of the first data units corresponds to one column of data written to the memory chips in parallel.

15. The method of claim 13, wherein each of the first data units corresponds to columns of data written to the memory chips in parallel.
